# EUROPEAN PATENT APPLICATION

(11) **EP 1 361 615 A2**
(43) Date of publication of application: **12.11.2003**
(21) Application number: 03076160.5
(22) Date of filing: 22.04.2003
(51) Int. Cl.: H01L 31/0203, H01L 31/02

(54) **Image sensor having a tape cover**

(30) Priority: 03.05.2002 US 138902
(71) Applicant: EASTMAN KODAK COMPANY, Rochester, New York 14650 (US)
(72) Inventor: Waldman, Jaime I., c/o Eastman Kodak Company, Rochester, New York 14650-2201 (US); Ciminelli, Mario J., c/o Eastman Kodak Company, Rochester, New York 14650-2201 (US)
(74) Representative: Haile, Helen Cynthia

(57) **Abstract**

An image sensor includes a substrate for forming a support structure; a plurality of photosensitive areas disposed in a cavity of the substrate so that a lip is formed enclosing at least a portion of the photosensitive areas; and a light-transmitting tape having an adhesive side removably attached to the lip and extending over the photosensitive area for permitting the photosensitive areas to receive light, for protecting the photosensitive areas from debris and for providing a efficient mechanism for removing the tape if desired.

## Description

The invention relates generally to the field of temporary covers for protecting image sensors and, more particularly, to a transparent tape cover for covering the of the image sensor.

A typical prior art sensor is provided in a supporting substrate such that the image sensor is positioned below the top surface of the substrate. A plurality of connecting leads are attached to the substrate which leads are used to electrically connect the image sensor to a circuit board. Some image sensors include charge-coupled devices (CCDs) for their image capture. Such charge-coupled devices are sensitive to particles, susceptible to damage and can be very expensive in various applications. It is essential with CCDs to conduct preliminary optical tests on the image sensor prior to installation. Often, it is necessary to run a final test after the image sensor is installed in a product. In order to protect the CCD from particles and minimize any potential damage to the image sensor, a clear cover glass is usually placed directly over the substrate so that it covers both the CCD and the substrate. The cover glass is typically provided with a seal of epoxy placed around its perimeter.

Image sensors are available to customers with a permanent or temporary covers. Devices with permanent cover glass lose some light due to the reflection and transmission losses of the glass. The amount of light loss depends on several properties of the glass material. In contrary, devices with temporary covers do not have this problem because they are removed in service. A second need for a CCD without a permanently bonded cover is when a customer needs to bond a glass fiber bundle optic to the surface of the CCD allowing a very tight clearance between the glass fiber bundle and the CCD. Although, permanent-sealing covers lose more light than devices without covers, they provide a better moisture barrier and particle protection to the image sensor. It is up to the customer to decide whether a permanent or temporary cover will better fit their product.

When it is desired to provide a permanent seal, then the epoxy side of the glass cover is placed directly against the top surface of the substrate. When it is desired to provide a temporary cover, then the covered glass is placed on the substrate and the tape is used to hold the cover glass to the substrate or a snap on plastic lid is used as described in U.S. Patent 6,184,514. When the cover glass is to be temporarily mounted to the substrate an adhesive tape is used to secure the cover glass to the substrate. The process of applying the tape in securing the cover glass can be a tedious and time-consuming operation. A further problem with prior art of the plastic snap on lid is that it does not have a seal between the plastic and the substrate. Particles may therefore travel between the plastic and the substrate and migrate to the active area of the image sensor.

If particles are found on devices with the temporary cover, then the lid must be removed in order to clean the particles. If the problem is fixed, then the temporary cover must be re-attached to the substrate. However, if the cover is contaminated with particles or scratches, a new temporary cover must be used for the device.

Consequently, there is a need to provide an improved temporary cover that is inexpensive, can be imaged through for optical testing, restricts the transfer of particles to the active area of the sensor, can be easily changed in the event of defects or particles, and/or may be easily removed after testing the sensor. It is also desirable to provide a process which minimizes the amount of labor necessary for applying the temporary cover.

The present invention addresses these needs and allows for further material cost reductions. Proper design of the tape lid also reduces the chance of damage to the image sensor or wirebonds upon removal as compared to a taped on glass lid or snap on plastic lid.

The present invention is directed to overcoming one or more of the problems set forth above. Briefly summarized, according to one aspect of the present invention, the invention resides in an image sensor comprising (a) a substrate for forming a support structure; (b) a plurality of photosensitive areas disposed in a cavity of the substrate so that a lip is formed enclosing at least a portion of the photosensitive areas; and (c) a light-transmitting tape having an adhesive side removably attached to the lip and extending over the photosensitive area for permitting the photosensitive areas to receive light, for protecting the photosensitve areas from debris and for providing a efficient mechanism for removing the tape if desired.

These and other aspects, objects, features and advantages of the present invention will be more clearly understood and appreciated from a review of the following detailed description of the preferred embodiments and appended claims, and by reference to the accompanying drawings.

The present invention has the following advantage of being cost effective, extremely easy to use, and provides a continuous seal to prevent particle intrusions.

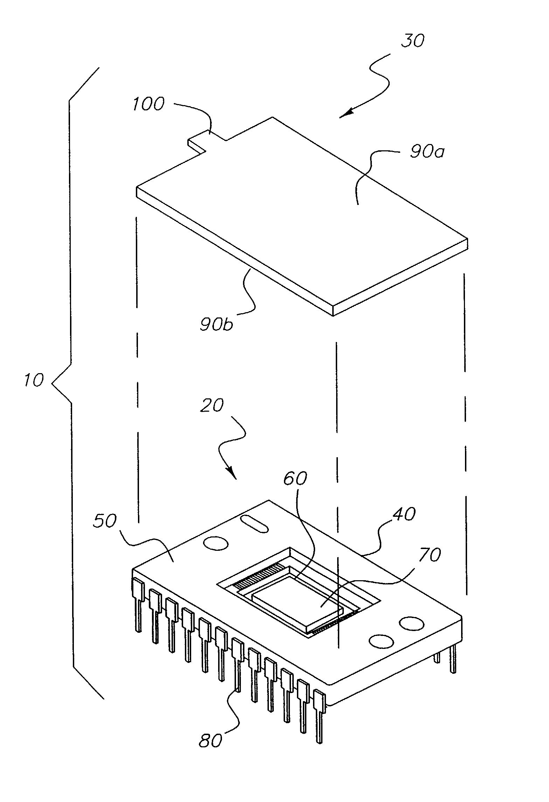

Fig. 1 is a perspective view of the image sensor and protective tape covering of the present invention.

Referring to the Fig. 1, there is illustrated a sensor and cover assembly 10 made in accordance with the present invention. The assembly 10 comprises a sensor assembly 20 and transparent tape 30. The sensor assembly 20 includes a supporting substrate 40 having a generally planer upper surface 50. The sensor substrate 40 is configured so as to provide a recessed cavity section 60 in which a sensor 70 is mounted in such that the sensor 70 is below the planer upper surface 50. The substrate 40 may be made of any typical material currently used or may be used in the future. The sensor assembly 20 further includes a plurality of electrical leads 80 which are used to mount the sensor mounting assembly 20 to a circuit board, not shown, in the manner typically used in the prior art and provide electrical connection to sensor 70. In the particular embodiment illustrated, sensor 70 is an area array charged couple device (CCD) image sensor for capturing of images that are exposed onto the sensor. However, it is to be understood that sensor 70 may comprise of any other image sensor or other type of substrate if so desired.

The transparent tape 30 is preferably optically clear, light-transmitting, flexible and designed to be easily and quickly applied to or removed from the sensor mounting assembly 20. The transparent tape 30 includes two sides 90, an upward side 90a and a downward side 90b. The downward side 90b includes a sticky adhesive thereon which is also transparent and optically clear so that light is permitted to pass therethrough. The downward side 90b is manually pressed against the planar upper surface 50 and over the sensor 70 for protecting the sensor 70. The adhesive maintains the tape 30 on the surface 50 as is readily apparent. The tape 30 is removed by manually lifting the tape 30, preferably by the tab 100, which is flexed upwardly and toward the opposite end in a peeling-off manner. The tape is preferably anti-static in nature but is not mandatory.

## Claims

1. An image sensor comprising:
(a) a substrate for forming a support structure;
(b) a plurality of photosensitive areas disposed in a cavity of the substrate so that a lip is formed enclosing at least a portion of the photosensitive areas; and
(c) a light-transmitting tape having an adhesive side removably attached to the lip and extending over the photosensitive area for permitting the photosensitive areas to receive light, for protecting the photosensitive areas from debris and for providing a efficient mechanism for removing the tape if desired.

2. The image sensor as in claim 1, wherein the adhesive is flexible for permitting the tape to be removed by manual peeling.

3. The image sensor as in claim 1, wherein the tape is entirely transparent.

4. The image sensor as in claim 2 further comprising a tab disposed at an end of the tape for facilitating in removal of the tape.

5. A method for providing protective packaging for an image sensor, the method comprising the steps of:
(a) providing a substrate for forming a support structure;
(b) providing a plurality of photosensitive areas disposed in a cavity of the substrate so that a lip is formed enclosing at least a portion of the photosensitive areas; and
(c) attaching to the lip a light transmitting tape having an adhesive side which tape extends over the photosensitive area for permitting the photosensitive areas to receive light, for protecting the photosensitive areas from debris and for providing a efficient manual mechanism for removing the tape.

6. The method as in claim 5 further comprising the step of peeling the tape away for removal of the tape.

7. The method as in claim 5, wherein step (c) includes providing an entirely transparent tape.

8. The method as in claim 6 further comprising the step of providing a tab for facilitating in removal of the tape.
